# EUROPEAN PATENT APPLICATION

(11) **EP 2 722 142 A1**
(43) Date of publication of application: **23.04.2014**
(21) Application number: 11867703.8
(22) Date of filing: 16.06.2011
(51) Int. Cl.: B27N 3/02

(54) **CIRCUIT-BOARD POWDER MADE ECO-FRIENDLY PANEL FREE FROM ALDEHYDE AND CARBON EMISSION AND PRODUCTION METHOD**

(71) Applicant: Guangdong Wep Energy-Saving Technology Co., Ltd., Foshan, Guangdong 528143 (CN)
(72) Inventor: XIAO, Chaofeng, Foshan, Guangdond 528143 (CN)
(74) Representative: Petraz, Gilberto Luigi
(86) International application number: PCT/CN2011/075835
(87) International publication number: WO 2012/171208

(57) **Abstract**

The present invention relates to a process of manufacturing a formaldehyde-free zero-carbon-emission environment-friendly plate made from circuit board powder, raw materials of the plate comprise circuit board powder, an isocyanate, a mold release agent, water, wood fiber powder and carbon fiber. These raw materials are mixed together and pressed to form the plate of the present invention. The weight percentage of circuit board powder in the plate can be as high as 95%, and the plate of the present invention has no bubbles therein and has excellent water-proofing performance.

## Description

### FIELD OF THE INVENTION

The present invention relates to an environment-friendly plate, and more particularly to a formaldehyde-free zero-carbon-emission environment-friendly plate made from circuit board powder. The present invention also relates to a process of manufacturing a formaldehyde-free zero-carbon-emission environment-friendly plate made from circuit board powder.

### BACKGROUND OF THE INVENTION

Raw materials used for making traditional wood plates are forest woods, and deforestations are thus required to obtain these woods, which result in water loss and soil erosion and have adverse influences on the natural environment and ecological balance. Therefore, traditional wood plates are neither eco-friendly nor energy-saving. This kind of wood plate emits great amounts of formaldehyde, it is also prone to swelling, deformation, bending and going mouldy when wet, besides, it is not resistant to corrosion, acid or alkali, and is flammable.

Large amounts of building materials are needed due to the rapid development of cities around the world, these building materials include decorative plates used in industry and construction such as wooden deck, wooden plywood, low/medium/high density board, particle board and raw wood plates. However, none of these decorative plates utilizes renewable resource recycling technology, and it therefore requires large-scale deforestation, causing excessive deforestation and waste of timber resources. Excessive destruction of ecological environment disorders the ecological balance all over the world, incurs natural disasters such as frequent earthquakes, debris flow, floods, droughts, snow disasters and sand-dust storms, and results in global climate warming and serious environmental pollution. Excessive deforestation breaks the ecological balance, incurs water loss and soil erosion and worsens the environment, which leads to a sharp rise in the prices of raw materials of wood products.

Existing technique for manufacturing man-made plates always uses formaldehyde-contained diluent as a component of an adhesive formulation. When urea-formaldehyde resin or phenol-formaldehyde resin is used as a traditional adhesive, weight percentage of water in the adhesive will be very high, for example, weight percentage of water in the adhesive may exceed 12%, and lots of water vapor may thus be produced in chemical reactions between the adhesive and raw materials of plates during hot pressing process when manufacturing plates. When circuit board powder is used as a major ingredient for manufacturing plates, semifinished plates cannot absorb the water vapor under the action of both pressure and heat, which probably results in the formation of bubbles within semifinished plates. These bubbles will have a higher expansibility than internal stress during a subsequent pressure-relief process, which finally leads to cracks in plates.

### SUMMARY OF THE INVENTION

The present invention aims to provide a formaldehyde-free zero-carbon-emission environment-friendly plate made from circuit board powder and a manufacturing process thereof, the plate of the present invention is recyclable and has a high fiber content, besides, the cracking of plates will not happen during the manufacturing process of the present invention.

A technical solution of the present invention is a process of manufacturing a formaldehyde-free zero-carbon-emission environment-friendly plate made from circuit board powder, characterized in that, the process comprises the steps of:
(a) mixing an isocyanate and a mold release agent at a certain ratio and stirring uniformly;
(b) adding water to the mixture at a certain ratio and stirring uniformly to form plate-making minor ingredients;
(c) drying circuit board powder in a drying oven at a constant temperature of 125°C and stirring to control weight percentage of water in the circuit board powder not to exceed 3%;
(d) mixing dried circuit board powder and the plate-making minor ingredients at a certain ratio and stirring uniformly to form mixed raw materials, with weight percentage of water in the mixed raw materials not exceeding 10%;
(e) charging the mixed raw materials into a paving system with a constant charging speed, flattening the mixed raw materials using a flattening roller, pressing the mixed raw materials after they are entered into a pre-pressing machine to form semifinished plates having a uniform thickness, transporting the semifinished plates by using a conveying belt and then trimming vertically and horizontally, transporting plates to a multi-layer pressing machine or a steel-belt continuous flat pressing machine to perform a molding pressing; pressing for 1 minute to make pressure on the plate over 8 Mps, pressing for another 2 minutes with the pressure followed by a repressing with repressing pressure on the plate being over 11 Mps, repressing for 3 minutes followed by an air exhausting and pressure-relief process for at least 1 minute with pressure reduced gradually; wherein circulated heat conduction oil is used for heating a laminated board of the multi-layer pressing machine, and the circulated heat conduction oil of the laminated board has a temperature controlled between 150°C and 200°C;
(f) pulling out the plates after pressing, overturning the plates and wind cooling;
(g) sanding the plates, measuring thickness of the plates, quality testing and then storing.

Preferably, the circuit board powder is a powdered material obtained from disassembly and grinding of waste circuit board or circuit board scrap, or obtained from directly recycled drilling powder of circuit board; before the drying process in step (c), a vibrator is used to select the circuit board powder, and a magnet is used to remove metal impurity from the circuit board powder to avoid caking of raw materials of the plates.

Preferably, a step (c1) is added before the step (d), and the step (c1) comprises: performing a coarse crushing on a high-fiber auxiliary material, then crushing and grinding to process the high-fiber auxiliary material into wood fiber powder having a particle size of over 80 meshes, drying at a temperature of over 100 °C, controlling weight percentage of water in the wood fiber powder at a value between 2% and 4%; stirring and mixing the wood fiber powder at a temperature of 180 °C to obtain carbon fiber powder; mixing the circuit board powder and the carbon fiber powder at a certain ratio and then stirring uniformly; wherein the high-fiber auxiliary material is crop straw, wood saw dust or bamboo saw dust.

Preferably, a step (c2) is added before step (d), and the step (c2) comprises: adding a processing agent at a certain ratio and stirring uniformly again; wherein the processing agent comprises a curing agent, an antioxidant, carbon fiber or a mixture thereof.

Preferably, raw materials of the environment-friendly plate for pressing comprise: 80-97 parts of the circuit board powder, 3-12 parts of the isocyanate, 1-5 parts of the mold release agent, 1-8 parts of water, based on weight ratio.

The present invention also aims to provide a formaldehyde-free zero-carbon-emission environment-friendly plate made from circuit board powder and manufactured by the process as mentioned above, characterized in that, raw materials of the environment-friendly plate for pressing comprise: 50-97 parts of circuit board powder, 3-20 parts of an isocyanate, 1-5 parts of a mold release agent, 1-8 parts of water, based on weight ratio.

Preferably, raw materials of the environment-friendly plate for pressing comprise: 80-97 parts of circuit board powder, 3-12 parts of an isocyanate, 1-5 parts of a mold release agent, 3-6 parts of water, based on weight ratio.

Preferably, raw materials of the environment-friendly plate for pressing comprise: 80-97 parts of circuit board powder, 3-20 parts of an isocyanate, 1-5 parts of a mold release agent, 2-8 parts of water, 10-20 parts of wood fiber powder and 5-12 parts of carbon fiber, based on weight ratio.

Preferably, raw materials of the environment-friendly plate for pressing comprise: 80-97 parts of circuit board powder, 3-20 parts of an isocyanate, 1-5 parts of a mold release agent, 3-6 parts of water, 30-40 parts of wood fiber powder, 3-5 parts of a water-proofing agent, 3-5 parts of a fire-proofing agent, 7-10 parts of carbon fiber, 1.5-2 parts of a curing agent, 1.5-2 parts of an antioxidant, based on weight ratio.

Preferably, the mold release agent is paraffin, and the circuit board powder is recycled powder of waste circuit board.

The benefits of environment-friendly plate of the present invention are as follows. In the process of manufacturing the formaldehyde-free zero-carbon-emission environment-friendly plate made from circuit board powder, the isocyanate and the mold release agent are firstly mixed prior to the adding of water to make the water-soluble isocyanate fully mixed with water, then the mixture are stirred to form homogeneous plate-making minor ingredients. Weight percentage of water in the plate-making minor ingredients should be controlled to avoid excessive moisture accumulation, because the excessive moisture accumulation will lead to a subsequent inhomogeneous mixture of the plate-making minor ingredients and plate-making major ingredient, and at the same time, lead to a partial caking of said raw materials. Water used as a crosslinking agent (medium) enables crosslinking between the plate-making minor ingredients and major ingredient, and the plates of the present invention cannot be manufactured from powdered materials without water, besides, water in the powdered materials could also avoid the raising of dust. Therefore, water is an indispensable part in manufacturing the plate of the present invention. In order to avoid producing inhomogeneous mixture of the plate-making minor ingredients and major ingredient, weight percentage of water in these ingredients should be controlled at a relatively low level, preferably, water should be contained in both the plate-making minor ingredients and major ingredient. In the manufacturing process of present invention, the water-soluble isocyanate is fully mixed and reacted with water, in this way, the formation of bubbles during heating will thus be effectively avoided.

At a later stage of the process of manufacturing the plate of the present invention, the pressure-relief process is maintained for at least 1 minute with the pressure reduced gradually, so as to prevent a sudden change in external pressure on the plate. If the pressure difference between internal pressure of the plates caused by internal stress and heat and external pressure of the plates is beyond plates' maximum tolerable pressure, and at the same time, if water vapor produced from heated water or expansion produced by gasification of raw materials is not timely exhausted, cracks in plates can easily happen. The gradually reduced pressure facilitates exhaust of bubbles in plates and thus effectively lowers the cracking risk.

Plates made from the isocyanate and circuit board powder by using the above-mentioned manufacturing process are environment-friendly plates completely free of formaldehyde, the weight percentage of isocyanate in the plate can be as low as 3%, while the weight percentage of circuit board powder in the plate can be higher than 95%, in this way, rate of resource utilization of waste is largely increased and the cost of the plate can thus be lowered. Besides, the plate of the present invention has excellent water-proofing performance due to the water-proofing ability of circuit board powder. In the manufacturing process, the isocyanate absorbs and reacts with water, thereby weight percentage of water in raw materials of the plate can be decreased and water vapor can also be reduced, in this way, the formation of bubbles is unlikely to happen and the problem of cracks in plates can thus be solved.

### DETAILED DESCRIPTION OF THE PREFERRED EMBODIMENTS OF THE INVENTION

Detailed description of the preferred embodiments of the present invention is as follows.

The present invention provides a process of manufacturing a formaldehyde-free zero-carbon-emission environment-friendly plate made from circuit board powder, characterized in that, the process comprises the steps of:
(a) mixing an isocyanate and a mold release agent at a certain ratio and stirring uniformly;
(b) adding water to the mixture at a certain ratio and stirring uniformly to form plate-making minor ingredients;
(c) drying circuit board powder in a drying oven at a constant temperature of 125°C and stirring to control weight percentage of water in the circuit board powder not to exceed 3%; wherein the drying process is preferably conducted in an agitator dryer, and the stirring process is preferably performed in a speed increasing manner (from low speed initially to high speed later) so as to obtain a homogeneous mixture;
(d) mixing dried circuit board powder and the plate-making minor ingredients at a certain ratio and stirring uniformly to form mixed raw materials, with weight percentage of water in the mixed raw materials not exceeding 10%;
(e) charging the mixed raw materials into a paving system with a constant charging speed, flattening the mixed raw materials using a flattening roller, pressing the mixed raw materials after they are entered into a pre-pressing machine to form semifinished plates having a uniform thickness, transporting the semifinished plates by using a conveying belt and then trimming vertically and horizontally, transporting plates to a multi-layer pressing machine or a steel-belt continuous flat pressing machine to perform a molding pressing; pressing for 1 minute to make pressure on the plate over 8 Mps, pressing for another 2 minutes with the pressure followed by a repressing with repressing pressure on the plate being over 11 Mps, repressing for 3 minutes followed by an air exhausting and pressure-relief process for at least 1 minute with the pressure reduced gradually; wherein circulated heat conduction oil is used for heating a laminated board of the multi-layer pressing machine, and the circulated heat conduction oil of the laminated board has a temperature controlled between 150°C and 200°C; in this way, the circulated heat conduction oil which is flowing oil guarantees a high and uniform temperature in the laminated board, which prevents the plates from being damaged caused by uneven temperatures in the laminated board;
   wherein the pressing process is a step-by-step process rather than a one-step process, which facilitates interactions among ingredients of the plate, besides, it provides buffering time for the interaction; pressure maintaining is also provided during the pressing process, which prolongs time for crosslinking reaction among ingredients of the plate and leads to the production of stable plates; similarly, the pressure-relief process is also a step-by-step process, because external pressures on the plate and internal pressures in the plate might be inconsistent due to a sharply reduced pressure, the gradually reduced pressure can avoid many plate deficiencies, such as cracking, invisible cracking, inconsistent partial performance and lamination, therefore, the homogeneity, stability and durability of the plate of the present invention is further improved;
(f) pulling out the plates after pressing, overturning the plates, wind cooling and performing other regular procedures for making plates;
(g) sanding the plates, measuring thickness of the plates, quality testing and then storing.

In the process of manufacturing the formaldehyde-free zero-carbon-emission environment-friendly plate made from circuit board powder, the isocyanate and the mold release agent are firstly mixed prior to the adding of water to make the water-soluble isocyanate fully mixed with water, then the mixture are stirred to form homogeneous plate-making minor ingredients. Weight percentage of water in the plate-making minor ingredients should be controlled to avoid excessive moisture accumulation, because the excessive moisture accumulation will lead to a subsequent inhomogeneous mixture of the plate-making minor ingredients and plate-making major ingredient, and at the same time, lead to a partial caking of said raw materials. Water used as a crosslinking agent (medium) enables crosslinking between the plate-making minor ingredients and major ingredient, and the plates of the present invention cannot be manufactured from powdered materials without water, besides, water in the powdered materials could also avoid the raising of dust. Therefore, water is an indispensable part in manufacturing the plate of the present invention. In order to avoid producing inhomogeneous mixture of the plate-making minor ingredients and major ingredient, weight percentage of water in these ingredients should be controlled at a relatively low level, preferably, water should be contained in both the plate-making minor ingredients and major ingredient. In the manufacturing process of present invention, the water-soluble isocyanate is fully mixed and reacted with water, in this way, the formation of bubbles during heating will thus be effectively avoided.

At a later stage of the process of manufacturing the plate of the present invention, the pressure-relief process is maintained for at least 1 minute with the pressure reduced gradually, so as to prevent a sudden change in external pressure on the plate. If the pressure difference between internal pressure of the plates caused by internal stress and heat and external pressure of the plates is beyond plates' maximum tolerable pressure, and at the same time, if water vapor produced from heated water or expansion produced by gasification of raw materials is not timely exhausted, cracks in plates can easily happen. The gradually reduced pressure facilitates exhaust of bubbles in plates and thus effectively lowers the cracking risk.

Plates made from the isocyanate and circuit board powder by using the above-mentioned manufacturing process are environment-friendly plates completely free of formaldehyde, the weight percentage of isocyanate in the plate can be as low as 3%, while the weight percentage of circuit board powder in the plate can be higher than 95%, in this way, rate of resource utilization of waste is largely increased and the cost of the plate can thus be lowered. Besides, the plate of the present invention has excellent water-proofing performance due to the water-proofing ability of circuit board powder. In the manufacturing process, the isocyanate absorbs and reacts with water, thereby weight percentage of water in raw materials of the plate can be decreased and water vapor can also be reduced, in this way, the formation of bubbles is unlikely to happen and the problem of cracks in plates can thus be solved.

Water in the raw materials of plates begins to evaporate under the action of both pressure and heat, generated water vapor then destroys adhesive layer. When the pressure-relief process is applied to the plates at an outlet of a pressing machine, the plates are prone to cracking due to a higher expansibility than internal stress among the raw materials of plates. Isocyanate which is used as a raw material of the plates can react with water to produce amine and carbon dioxide, and produced amine further reacts with the isocyanate to produce substituted urea. Isocyanate contains unsaturated bond and has a relatively high reactivity, it can easily react with organic or inorganic chemicals having active group to produce polyurethane elastomer. Therefore, if an adhesive containing MDI isocyanate is added to raw materials of plates, the manufactured plates will have fewer bubbles therein and thus have lowers cracking risk.

As global electronic industry developed, the system for recycling old electrical appliances was gradually established. Various regions built up recycle centers to dismantle the appliances, metals and plastics were separated and recycled, harmful objects were handed to relevant department for further treatment, and remaining circuit boards would be buried under the ground, however, this way is unconscionable. Electronic industry produces large amount of circuit board scraps, most of the scraps are burned for extracting cooper, or the scraps are smashed for obtaining metal, then residual powders of the circuit board (or PCB, printed circuit board) are cleaned up or buried. Besides the residual powders, copper-clad laminates and drilling powders from the electronic industry are also cleaned up or buried. This generates large amount of electronic trash. Alone in China, over five million tons waste circuit board were produced every year, however, circuit board powder is thermoset resin powder which is not easy to degrade, and therefore directly discarding or burying of the circuit board powder does not match the requirement for saving energy. In the present invention, circuit boards obtained from discarded appliances or industry wastes are recycled, after crushing and extracting metal via electrostatic separation, the residual circuit board powder can be used as a major ingredient for making the plate of the present invention.

Preferably, the circuit board powder is a powdered material obtained from disassembly and grinding of waste circuit board or circuit board scrap, or obtained from directly recycled drilling powder of circuit board. Before the drying process in step (c), a vibrator is used to select the circuit board powder, and a magnet is used to remove metal impurity from the circuit board powder to avoid caking of the raw materials of the plate.

Preferably, a step (c1) is added before the step (d), and the step (c1) comprises: performing a coarse crushing on a high-fiber auxiliary material, then crushing and grinding to process the high-fiber auxiliary material into wood fiber powder having a particle size of over 80 meshes, drying at a temperature of over 100 °C, controlling weight percentage of water in the wood fiber powder at a value between 2% and 4%; stirring and mixing the wood fiber powder at a temperature of 180 °C to obtain carbon fiber powder. Wherein the stirring process can be conducted in a high-speed mixer so as to obtain carbon fiber powder that is easy to be mixed and crosslinked with other substances to form the plate, besides, the carbon fiber powder obtained in this manner has a better flexibility. In addition, a water-proofing agent and a fire-proofing agent can be added during stirring, in this way, high temperature burning can be prevented. The wood fiber powder can be pre-mixed with a water-proofing agent, such that the wood fiber powder can be protected from both water and fire. After that, the circuit board powder and the carbon fiber powder can be mixed at a certain ratio, and the mixture is then stirred uniformly.

The above mentioned high-fiber auxiliary material is crop straw, wood saw dust or bamboo saw dust. The process of manufacturing the formaldehyde-free zero-carbon-emission environment-friendly plate of the present invention comprises mixing circuit board powder and wood fiber powder produced from various straw, wood saw dust or bamboo saw dust, then adding a variety of additives and fully mixing these raw materials, pressing these raw materials by a strong pressure. The produced plate of the present invention is water-proof, fire-proof, anti-swelling, anti-deformation, anti-bending, mould-proof, corrosion-resistant, acid-resistant and alkali-resistant. In this way, the process of the present invention achieves the purpose of recycling various waste materials, avoiding excessive deforestation, and being beneficial for maintenance and restoration of the natural environment and ecological balance, reducing natural disasters, stabling plates price, and further achieving the effect of low-carbon and energy saving.

There is a large amount of production of straw in China, which is several hundred million tons, involving corn straw, wheat straw, rice straw, bagasse and others. Under the support of polices all over the world to agriculture, APEC members, in order to protect regional agricultural eco-environment, cooperate technically with each other on the recycling of crop straws. China produces large amounts of crop straws such as corn straw, cotton stalks, rice straw, wheat straw and bagasse, but these residues of crop are buried or burned instead of being used, producing carbon dioxide which is harmful to the environment, for example, it might incur climate warming and disrupt ecological balance. However, crop straw contains much wood fiber and can be recycled, wood fiber powder obtained by grinding the crop straw can be used as an ingredient for making plate. Existing dispose mold for the treatment of crop straw, wood saw dust or bamboo saw dust produced from agricultural production in China is landfill disposal or incineration, which is not environment-friendly or low-carbon.

Wood product industry (floor and furniture) and bamboo product industry generate much wood/bamboo saw dust, but these wood/bamboo saw dust are not effectively used again and are burned or buried. This not only wastes resources but also generates pollution. Nowadays, wood floor and laminated wood floor are popular but their life time is usually from 3 to 5 years. Because of the anti-fire layer pasted on the surface of the floors, these floors cannot be burnt but only buried when discarded, which increases environmental burdens. However, these discarded laminated floors can be grinded to wood powder with a particle size of over 80 meshes, i.e. wood fiber powder, and the powder can further be used as a filler for plates.

Using crop straws, wood saw dust or bamboo saw dust as the high-fiber auxiliary material can avoid harming the environment by recycling wastes, reduce the weight of plate and improve flexibility and strengthen of the plate, make the plate similar to wood, such that, the plate of the present invention is able to be sawed, drilled, profiled processed and profiled pressed.

Preferably, a step (c2) is added before step (d), and the step (c2) comprises: adding a processing agent at a certain ratio and stirring uniformly again; wherein the processing agent comprises a curing agent, an antioxidant, carbon fiber or a mixture thereof. Main raw materials are fully mixed prior to the adding of processing agent, which ensures a complete crosslinking reaction among the main raw materials. The processing agent can include a water-proofing agent, and the water-proofing agent is one or more selected from the group consisting of paraffin, silicone oil, white oil and palm wax. The water-proofing agent can be added into the high-fiber auxiliary material in advance so as to form a protective coating on the surface of the high-fiber auxiliary material. The plates manufactured by this method can be planed, nailed and sawed like wood, which is convenient for processing, and the plates are renewable. By adding chopped carbon fiber and various composite agents, internal and external stress tolerance of the plates are enhanced, in addition, impact strength, static strength and static bending strength of the plates are also improved.

Preferably, raw materials of the environment-friendly plate for pressing comprise: 80-97 parts of the circuit board powder, 3-12 parts of the isocyanate, 1-5 parts of the mold release agent, 1-8 parts of water, based on weight ratio. The plate produced by using said weight ratios of raw materials substantially has no cracks and has high internal bond strength, static bending strength, elastic modulus, screw holding capabililty and density, and low deviation of density.

In order to produce a renewable plate without cracks by using the above mentioned manufacturing process, the present invention provides the following raw materials: 50-97 parts of circuit board powder, 3-20 parts of an isocyanate, 1-5 parts of a mold release agent, 1-8 parts of water, based on weight ratio.

Preferably, raw materials of the environment-friendly plate for pressing comprise: 80-97 parts of the circuit board powder, 3-12 parts of the isocyanate, 1-5 parts of the mold release agent, 3-6 parts of water, based on weight ratio.

Preferably, raw materials of the environment-friendly plate for pressing comprise: 80-97 parts of the circuit board powder, 3-20 parts of the isocyanate, 1-5 parts of the mold release agent, 2-8 parts of water, 10-20 parts of wood fiber powder and 5-12 parts of carbon fiber, based on weight ratio.

The plate which is made by mixing circuit board powder with the wood fiber powder produced from various straw, wood saw dust or bamboo saw dust has high strength inherited from the circuit board and also has good flexibility and low density inherited from the wood fiber powder. Therefore, the plate of the present invention reduces construction products' load duo to the light weight of the plate; the plate also has an improved static strength and static bending strength; in addition, the plate is easy to process and can be pressed to any shape.

Using powder recycled from waste circuit board and/or drilling powder of circuit board as main filling material for plates is good for environment. Because circuit board (CCL and/or PCB) powder is manly consisted of epoxy and glass fiber, the plate made from the powder as an ingredient is thus water-proof, anti-deformation, anti-swelling, mould-proof, corrosion-resistant, acid-resistant and alkali-resistant, and has no formaldehyde emission, and can also be recycled.

Adding carbonized wood fiber powder can reduce the weight of plate, save the cost of logistics, improve the internal and external stress, enhance the static strength and static bending strength of the plate and widen the usability of the plate, the plate can thus be pressed to any bumpy texture that seems archaistic. Adding wood fiber powder can provide the plate with fiber adhesive strength, this improves the elasticity of the plate, which facilitates post-processing of the plate.

Preferably, raw materials of the environment-friendly plate for pressing comprise: 80-97 parts of the circuit board powder, 3-20 parts of the isocyanate, 1-5 parts of the mold release agent, 3-6 parts of water, 30-40 parts of the wood fiber powder, 3-5 parts of a water-proofing agent, 3-5 parts of a fire-proofing agent, 7-10 parts of the carbon fiber, 1.5-2 parts of a curing agent, 1.5-2 parts of an antioxidant, based on weight ratio; wherein the carbon fiber is glass fiber.

Preferably, the mold release agent is paraffin, and the circuit board powder is recycled powder of waste circuit board. Using circuit board powder to produce plates recycles waste, making waste profitable.

Paraffin also has water-proofing effect. In the present invention, the water-proofing agent is one or more selected from the group consisting of paraffin, silicone oil, white oil and palm wax, preferably, the waterproofing agent is the emulsion of paraffin. The water-proofing agent prevents both the wood fiber powder and the circuit board powder of the plate of the present invention from deformation when wet and therefore achieves mould-proofing and corrosion-resistance effects. The fire-proofing agent is one or more selected from the group consisting of ammonium chloride, potassium carbonate and ammonium dihydrogen phosphate. The carbon fiber is glass fiber. The curing agent is one or more selected from the group consisting of ammonium chloride, oxalic acid, phenolic aldehyde amine, polyether amine and aromatic amine. The antioxidant is one or more selected from the group consisting of aromatic amine antioxidant, phenolic antioxidant, thioester and phosphite eater.

Preferably, the fire-proofing agent is one or more selected from the group consisting of ammonium chloride, potassium carbonate and ammonium dihydrogen phosphate. Formaldehyde catching agent is one or more selected from the group consisting of montmorillonite, melamine and phenol. The curing agent is one or more selected from the group consisting of ammonium chloride, oxalic acid, phenolic aldehyde amine, polyether amine and aromatic amine. The antioxidant is one or more selected from the group consisting of aromatic amine antioxidant, phenolic antioxidant, thioester and phosphite eater.

In the present invention, the fire-proofing agent is one or more selected from the group consisting of ammonium chloride, potassium carbonate and ammonium dihydrogen phosphate, optionally, phosphorus-nitrogen-boron-molybdenum-magnesium-zinc-aluminum composition can also be added as an fire-proofing agent for the plate of the present invention, the fire-proofing agent (i.e. fire retardant) is then homogeneous distributed on surface of fine fiber. The fire retardant produces acid and forms dehydrant when meets high temperature, and the flame retardant system will react violently as the temperature increased, producing water vapor and incombustible gas which is also regarded as fire retardant gas, at the same time, the system expands and foams, forming porous foam carbonized layers. Because the water vapor and incombustible gas can dilute concentrations of combustible substance in the plate, and the carbonized layers can further retard inflaming and prevent oxygen entering, the plate of the present invention has an ideal fireproof performance which can reach a level of Bfl. In addition, a smoke-proofing agent can be blended with the fireproofing agent to effectively reduce smoke concentrations.

In the present invention, the carbon fiber is glass fiber, and the carbon fiber should be chopped carbon fiber whose length is between 3 mm and 25 mm, which can increase the strength of the plate and strengthen the bearing capacity of an entire plate.

In the present invention, the curing agent is one or more selected from the group consisting of ammonium chloride, oxalic acid, phenolic aldehyde amine, polyether amine and aromatic amines, preferably, ammonium chloride is used. The curing agent can accelerate curing process and shorten the production cycle. Newly produced plate of the present invention is not frangible and can be applied to next processing steps immediately as soon as it has been produced.

In the present invention, the antioxidant is one or more selected from the group consisting of aromatic amines antioxidant, phenolic antioxidant, thioester and phosphite ester, preferably, phosphite ester is used. The antioxidant prevents plate's oxidation and aging resulted from the influence of climate and temperature during long-time use.

In the present invention, the fire-proofing agent, chopped carbon fiber, curing agent, antioxidant and stabilizer which are used as ingredients of the plate can improve plates' compatibility and adhesive strength, enhance stability, avoid oxidation, give wood flavor, prevent fire and meet other requirements of decorative plates.

After performing lots of experiments, raw materials and the amounts thereof for making the formaldehyde-free zero-carbon-emission environment-friendly plate made from circuit board powder of the present invention are as follows.

Example 1: raw materials of the formaldehyde-free zero-carbon-emission environment-friendly plate for pressing comprise: 97 parts of circuit board powder, 3 parts of isocyanate, 1 part of paraffin and 4 parts of water, based on weight ratio.

Example 2: raw materials of the formaldehyde-free zero-carbon-emission environment-friendly plate for pressing comprise: 97 parts of circuit board powder, 20 parts of isocyanate, 5 parts of paraffin and 8 parts of water, based on weight ratio.

Example 3: raw materials of the formaldehyde-free zero-carbon-emission environment-friendly plate for pressing comprise: 50 parts of circuit board powder, 8 parts of isocyanate, 3 parts of paraffin and 1 part of water, based on weight ratio.

Example 4: raw materials of the formaldehyde-free zero-carbon-emission environment-friendly plate for pressing comprise: 75 parts of circuit board powder, 12 parts of isocyanate, 2 parts of paraffin and 3 parts of water, based on weight ratio.

Example 5: raw materials of the formaldehyde-free zero-carbon-emission environment-friendly plate for pressing comprise: 50 parts of circuit board powder, 10 parts of isocyanate, 4 parts of paraffin and 3 parts of water, based on weight ratio.

Example 6: raw materials of the formaldehyde-free zero-carbon-emission environment-friendly plate for pressing comprise: 80 parts of circuit board powder, 12 parts of isocyanate, 4 parts of paraffin and 5 parts of water, based on weight ratio.

Example 7: raw materials of the formaldehyde-free zero-carbon-emission environment-friendly plate for pressing comprise: 97 parts of circuit board powder, 12 parts of isocyanate, 5 parts of paraffin and 6 parts of water, based on weight ratio.

Example 8: raw materials of the formaldehyde-free zero-carbon-emission environment-friendly plate for pressing comprise: 80 parts of circuit board powder, 3 parts of isocyanate, 1 part of paraffin and 3 parts of water, based on weight ratio.

Example 9: raw materials of the formaldehyde-free zero-carbon-emission environment-friendly plate for pressing comprise: 90 parts of circuit board powder, 8 parts of isocyanate, 3 parts of paraffin and 4 parts of water, based on weight ratio.

Example 10: raw materials of the formaldehyde-free zero-carbon-emission environment-friendly plate for pressing comprise: 80 parts of circuit board powder, 12 parts of isocyanate, 4 parts of paraffin, 6 parts of water, 10 parts of wood fiber powder and 8 parts of carbon fiber, based on weight ratio.

Example 11: raw materials of the formaldehyde-free zero-carbon-emission environment-friendly plate for pressing comprise: 97 parts of circuit board powder, 12 parts of isocyanate, 5 parts of paraffin, 8 parts of water, 20 parts of wood fiber powder and 5 parts of carbon fiber, based on weight ratio.

Example 12: raw materials of the formaldehyde-free zero-carbon-emission environment-friendly plate for pressing comprise: 80 parts of circuit board powder, 3 parts of isocyanate, 1 part of paraffin, 2 parts of water, 20 parts of wood fiber powder and 12 parts of carbon fiber, based on weight ratio.

Example 13: raw materials of the formaldehyde-free zero-carbon-emission environment-friendly plate for pressing comprise: 90 parts of circuit board powder, 8 parts of isocyanate, 3 parts of paraffin, 4 parts of water, 15 parts of wood fiber powder and 12 parts of carbon fiber, based on weight ratio.

Example 14: raw materials of the formaldehyde-free zero-carbon-emission environment-friendly plate for pressing comprise: 80 parts of circuit board powder, 12 parts of isocyanate, 4 parts of paraffin, 5 parts of water, 10 parts of wood fiber powder, 3 parts of ammonium chloride, 8 parts of carbon fiber, 1.5 parts of ammonium chloride and 1.9 parts of phosphite ester, based on weight ratio.

Example 15: raw materials of the formaldehyde-free zero-carbon-emission environment-friendly plate for pressing comprise: 97 parts of circuit board powder, 12 parts of isocyanate, 5 parts of paraffin, 6 parts of water, 20 parts of wood fiber powder, 4 parts of ammonium chloride, 10 parts of carbon fiber, 1.5 parts of ammonium chloride and 1.5 parts of phosphite ester, based on weight ratio.

Example 16: raw materials of the formaldehyde-free zero-carbon-emission environment-friendly plate for pressing comprise: 80 parts of circuit board powder, 3 parts of isocyanate, 1 part of paraffin, 3 parts of water, 20 parts of wood fiber powder, 5 parts of ammonium chloride, 7 parts of carbon fiber, 1.8 parts of ammonium chloride and 1.8 parts of phosphite ester, based on weight ratio.

Example 17: raw materials of the formaldehyde-free zero-carbon-emission environment-friendly plate for pressing comprise: 90 parts of circuit board powder, 8 parts of isocyanate, 3 parts of paraffin, 4 parts of water, 15 parts of wood fiber powder, 5 parts of ammonium chloride, 7 parts of carbon fiber, 2 parts of ammonium chloride and 2 parts of phosphite ester, based on weight ratio.

Plates made from the ingredients in the above examples were tested for various parameters according to national standard LY/T1611-2003 which is suitable for testing high-density artificial plate, and the experimental results are as follows.

| Test items | 24h Absorbent thickness expansion rate,% | Internal bond strength, MPa | Static bending strength, Mpa | Bending elastic modulus, Mpa | Screw holding capability, N |
|---|---|---|---|---|---|
| Standard (superior product) | ≤4.0 | ≥1.2 | ≥40 | ≥3500 | ≥1000 |
| Example 1 | 0.85 | 3.63 | 55.7 | 4850 | 3730 |
| Example 2 | 0.64 | 3.72 | 53.3 | 4800 | 3690 |
| Example 3 | 0.66 | 3.83 | 53.9 | 4760 | 3670 |
| Example 4 | 0.67 | 3.86 | 56.1 | 4790 | 3750 |
| Example 5 | 0.71 | 3.96 | 54.6 | 4720 | 3640 |
| Example 6 | 0.64 | 3.77 | 54.7 | 4760 | 3690 |
| Example 7 | 0.62 | 3.87 | 54.5 | 4820 | 3720 |
| Example 8 | 0.78 | 3.80 | 55.3 | 4790 | 3670 |
| Example 9 | 0.55 | 3.92 | 56.3 | 4820 | 3750 |
| Example 10 | 0.67 | 3.78 | 56.6 | 4820 | 3690 |
| Example 11 | 0.82 | 3.89 | 55.8 | 4800 | 3730 |
| Example 12 | 0.71 | 3.72 | 55.2 | 4780 | 3660 |
| Example 13 | 0.72 | 3.75 | 55.6 | 4780 | 3760 |
| Example 14 | 0.63 | 3.82 | 55.2 | 4800 | 3680 |
| Example 15 | 0.83 | 3.86 | 55.7 | 4830 | 3780 |
| Example 16 | 0.75 | 3.72 | 55.1 | 4790 | 3700 |
| Example 17 | 0.76 | 3.93 | 55.8 | 4850 | 3730 |

Plates made from the above ingredients and manufactured by the processes of the present invention also have the following satisfactory performances: the detected concentration of formaldehyde emission is zero (E0 ≤ 0.5 mg/100g was required in the standard); the density of the plates is greater than 1.39 kg/m³ (density ≥ 0.8 kg/m³ was required in the standard); the density deviation ranges: +0.63%, -1.26% (deviation ≤ 4.0% was required in the standard).

The paraffin used as a water-proofing agent in the above-mentioned examples can be replaced with one or more components selected from the group consisting of paraffin, silicone oil, white oil and palm wax, because this replacement led to a performance difference less than 3.5% for the plates after repeated tests.

The ammonium chloride used as a fire-proofing agent in the above-mentioned examples can be replaced with potassium carbonate and/or ammonium dihydrogen phosphate, because this replacement led to a performance difference less than 5% for the plates after repeated tests.

The carbon fiber is chopped glass fiber.

The ammonium chloride used as a curing agent in the above-mentioned examples can be replaced with one or more components selected from the group consisting of oxalic acid, phenolic aldehyde amine, polyether amine and aromatic amines, because this replacement led to a performance difference less than 3% for the plates after repeated tests.

The phosphite ester used as an antioxidant in the above-mentioned examples can be replaced with one or more components selected from the group consisting of aromatic amines antioxidant, phenolic antioxidant and thioester, because this replacement led to a performance difference less than 3.6 % for the plates after repeated tests.

All the above are the preferred embodiments of the present invention, and the invention is intended to cover various modifications and equivalent arrangements included within the scope of the invention.

## Claims

1. A process of manufacturing a formaldehyde-free zero-carbon-emission environment-friendly plate made from circuit board powder, **characterized in that**, the process comprises the steps of:
(a) mixing an isocyanate and a mold release agent at a certain ratio and stirring uniformly;
(b) adding water to the mixture at a certain ratio and stirring uniformly to form plate-making minor ingredients;
(c) drying circuit board powder in a drying oven at a constant temperature of 125°C and stirring to control weight percentage of water in the circuit board powder not to exceed 3%;
(d) mixing dried circuit board powder and the plate-making minor ingredients at a certain ratio and stirring uniformly to form mixed raw materials, with weight percentage of water in the mixed raw materials not exceeding 10%;
(e) charging the mixed raw materials into a paving system with a constant charging speed, flattening the mixed raw materials using a flattening roller, pressing the mixed raw materials after they are entered into a pre-pressing machine to form semifinished plates having a uniform thickness, transporting the semifinished plates by using a conveying belt and then trimming vertically and horizontally, transporting plates to a multi-layer pressing machine or a steel-belt continuous flat pressing machine to perform a molding pressing; pressing for 1 minute to make pressure on the plate over 8 Mps, pressing for another 2 minutes with the pressure followed by a repressing with repressing pressure on the plate being over 11 Mps, repressing for 3 minutes followed by an air exhausting and pressure-relief process for at least 1 minute with pressure reduced gradually; wherein circulated heat conduction oil is used for heating a laminated board of the multi-layer pressing machine, and the circulated heat conduction oil of the laminated board has a temperature controlled between 150°C and 200°C;
(f) pulling out the plates after pressing, overturning the plates and wind cooling;
(g) sanding the plates, measuring thickness of the plates, quality testing and then storing.

2. The process of manufacturing a formaldehyde-free zero-carbon-emission environment-friendly plate made from circuit board powder as claimed in claim 1, **characterized in that**, the circuit board powder is a powdered material obtained from disassembly and grinding of waste circuit board or circuit board scrap, or obtained from directly recycled drilling powder of circuit board; before the drying process in step (c), a vibrator is used to select the circuit board powder, and a magnet is used to remove metal impurity from the circuit board powder to avoid caking of raw materials of the plates.

3. The process of manufacturing a formaldehyde-free zero-carbon-emission environment-friendly plate made from circuit board powder as claimed in claim 1, **characterized in that**, a step (c1) is added before the step (d), and the step (c1) comprises: performing a coarse crushing on a high-fiber auxiliary material, then crushing and grinding to process the high-fiber auxiliary material into wood fiber powder having a particle size of over 80 meshes, drying at a temperature of over 100 °C, controlling weight percentage of water in the wood fiber powder at a value between 2% and 4%; stirring and mixing the wood fiber powder at a temperature of 180 °C to obtain carbon fiber powder; mixing the circuit board powder and the carbon fiber powder at a certain ratio and then stirring uniformly; wherein the high-fiber auxiliary material is crop straw, wood saw dust or bamboo saw dust.

4. The process of manufacturing a formaldehyde-free zero-carbon-emission environment-friendly plate made from circuit board powder as claimed in claim 3, **characterized in that**, a step (c2) is added before step (d), and the step (c2) comprises: adding a processing agent at a certain ratio and stirring uniformly again; wherein the processing agent comprises a curing agent, an antioxidant, carbon fiber or a mixture thereof.

5. The process of manufacturing a formaldehyde-free zero-carbon-emission environment-friendly plate made from circuit board powder as claimed in claim 1, **characterized in that**, raw materials of the environment-friendly plate for pressing comprise: 80-97 parts of the circuit board powder, 3-12 parts of the isocyanate, 1-5 parts of the mold release agent and 1-8 parts of water, based on weight ratio.

6. A formaldehyde-free zero-carbon-emission environment-friendly plate made from circuit board powder and manufactured by the process as claimed in claim 1, **characterized in that**, raw materials of the environment-friendly plate for pressing comprise: 50-97 parts of circuit board powder, 3-20 parts of an isocyanate, 1-5 parts of a mold release agent and 1-8 parts of water, based on weight ratio.

7. The formaldehyde-free zero-carbon-emission environment-friendly plate as claimed in claim 6, **characterized in that**, the raw materials of the environment-friendly plate for pressing comprise: 80-97 parts of the circuit board powder, 3-12 parts of the isocyanate, 1-5 parts of the mold release agent and 3-6 parts of water, based on weight ratio.

8. The formaldehyde-free zero-carbon-emission environment-friendly plate as claimed in claim 6, **characterized in that**, the raw materials of the environment-friendly plate for pressing comprise: 80-97 parts of the circuit board powder, 3-20 parts of the isocyanate, 1-5 parts of the mold release agent, 2-8 parts of water, 10-20 parts of wood fiber powder and 5-12 parts of carbon fiber, based on weight ratio.

9. The formaldehyde-free zero-carbon-emission environment-friendly plate as claimed in claim 6, **characterized in that**, the raw materials of the environment-friendly plate for pressing comprise: 80-97 parts of the circuit board powder, 3-20 parts of the isocyanate, 1-5 parts of the mold release agent, 3-6 parts of water, 30-40 parts of wood fiber powder, 3-5 parts of a water-proofing agent, 3-5 parts of a fire-proofing agent, 7-10 parts of carbon fiber, 1.5-2 parts of a curing agent and 1.5-2 parts of an antioxidant, based on weight ratio.

10. The formaldehyde-free zero-carbon-emission environment-friendly plate as claimed in any of claims 7- 9, **characterized in that**, the mold release agent is paraffin, and the circuit board powder is recycled powder of waste circuit board.
